# FASCICULE DE BREVET EUROPEEN

(11) **EP 4 507 006 B1**
(45) Date de publication et mention de la délivrance du brevet: **25.02.2026**
(21) Numéro de dépôt: 24193486.8
(22) Date de dépôt: 08.08.2024
(51) Int. Cl.: H10D 30/67, H10D 62/80, H10D 99/00, H10D 30/47, H10D 64/01, B82Y 10/00

(54) **PROCÉDÉ DE RÉALISATION D'UN DISPOSITIF MICROÉLECTRONIQUE COMPRENANT UNE GRILLE ENROBANTE**
VERFAHREN ZUR HERSTELLUNG EINER MIKROELEKTRONISCHEN VORRICHTUNG MIT EINEM INTEGRIERTEN GATE
METHOD FOR MANUFACTURING A MICROELECTRONIC DEVICE COMPRISING A CONFORMAL GATE

(30) Priorité: 11.08.2023 FR 2308689
(43) Date de publication de la demande: 12.02.2025
(73) Titulaire: Commissariat à l'Energie Atomique et aux Energies Alternatives, 75015 Paris (FR)
(72) Inventeur: BARRAUD, Sylvain, 38054 Grenoble Cedex 09 (FR)
(74) Mandataire: Hautier IP

(56) Documents cités:
- CN-A- 113 707 605
- US-A1- 2016 204 204
- US-A1- 2021 135 015
- US-A1- 2022 077 321
- US-A1- 2023 093 343
- US-B1- 10 388 732

## Description

### DOMAINE TECHNIQUE

L'invention concerne le domaine des technologies de la microélectronique. Elle trouve pour application particulièrement avantageuse la fabrication de dispositifs avancés de type FET (« Field-Effect Transistor » en anglais, ou transistor à effet de champ) à grille enrobante et à canal à base de matériaux semi-conducteurs, notamment à base de matériaux bidimensionnels (2D) ou d'oxydes semiconducteurs.

### ETAT DE LA TECHNIQUE

L'augmentation constante des performances des transistors a d'abord été permise par la réduction des dimensions des transistors, pour une architecture MOSFET (« Metal-Oxide-Semiconductor Field-Effect Transistor » signifiant transistor à effet de champ Métal-Oxyde-Semiconducteur) classique basée sur le silicium.

Cette architecture classique a ensuite laissé place à d'autres types d'architectures mieux adaptées aux performances spécifiées dans les nœuds technologiques inférieurs à 12 nm. L'architecture dite « finFET » permet par exemple de répondre aux performances fixées par les nœuds technologiques 7 nm et 5 nm.

Pour les prochains nœuds technologiques, notamment à partir de 3 nm et en deçà, d'autres architectures offrant un meilleur contrôle électrostatique sont nécessaires. Une architecture envisagée pour répondre aux problématiques de ces prochains nœuds technologiques comprend des transistors à grille enrobante dits transistors GAA (acronyme de Gate All Around), empilés les uns sur les autres.

En parallèle du développement de nouvelles architectures, d'autres matériaux que le silicium sont envisagés pour la fabrication des canaux des transistors. Récemment les matériaux 2D, qui peuvent être constitués d'une seule couche d'atomes, sont apparus comme des candidats prometteurs pour une utilisation dans les dispositifs électroniques et optoélectroniques comprenant un ou des éléments de très faibles épaisseurs.

Le document « Challenges of Wafer-Scale Integration of 2D Semiconductors for High-Performance Transistor Circuits, Tom Schram et al., Adv. Mater., 2109796 (2022) » divulgue un procédé de fabrication de transistors GAA superposés comprenant un canal à base de matériau 2D. Dans ce procédé, les matériaux 2D envisagés sont des dichalcogénures de métaux de transition sous forme de monocouches. Ces matériaux 2D se dégradent facilement lorsqu'ils sont soumis à un budget thermique moyen. Or les différentes étapes du procédé divulgué par ce document impliquent un budget thermique conséquent, susceptible de dégrader thermiquement les monocouches de matériau 2D. Il apparaît également que les étapes de formation des espaceurs internes et de remplacement de la grille sacrificielle impliquent que des parties des monocouches de matériau 2D soient librement suspendues. Les sollicitations mécaniques subies par les monocouches de matériau 2D sont également susceptibles de dégrader la structure finale et/ou les performances visées. Les aspects thermique et/ou mécanique de ce procédé de fabrication ne sont pas complétement appropriés aux monocouches de matériau 2D. Par conséquent, le développement d'un tel procédé nécessite des modifications et adaptations significatives des procédés technologiques existants. Les modifications et adaptations proposées jusqu'à ce jour imposent des coûts supplémentaires et/ou des limitations pour la fabrication industrielle de transistors GAA à base de matériaux 2D.

Le document US 2021/0135015 A1 divulgue un procédé de fabrication de transistors à effet de champ comprenant un matériau bidimensionnel (2D) en tant que région de canal. Le procédé comprend la formation d'un empilement d'un premier matériau semi-conducteur et d'un second matériau semi-conducteur. Une structure de grille sacrificielle et des espaceurs de grille sont ensuite formés sur l'empilement. Le premier matériau semi-conducteur est éliminé de manière sélective afin de définir des zones dans lesquelles le matériau bidimensionnel (2D) est formé. Le matériau bidimensionnel (2D) est également formé sur les espaceurs de grille. Par la suite, le second matériau semi-conducteur est retiré, et une structure de grille de remplacement, comprenant un diélectrique de grille, est formée sur le matériau bidimensionnel (2D).

Un autre procédé de fabrication de transistors à effet de champ comprenant un matériau bidimensionnel (2D) est connu du document US 2023/0093343 A1.

Une fabrication industrielle maîtrisée, satisfaisant aux exigences de qualité requises, est un enjeu important pour le développement des technologies de transistors GAA à base de matériaux 2D.

Il existe donc un besoin pour un procédé de fabrication de transistors GAA à base de matériaux 2D présentant une reproductibilité améliorée et un coût de fabrication limité.

Un objectif de l'invention est de proposer un tel procédé de fabrication reproductible, maîtrisé et limitant le coût de fabrication. Un autre objectif de l'invention est de pallier au moins en partie les inconvénients des procédés connus.

### RESUME

Pour atteindre ces objectifs, selon un mode de réalisation on prévoit un procédé de fabrication d'un dispositif microélectronique comprenant au moins au moins un transistor comprenant au moins deux canaux à base d'un matériau semiconducteur, une grille entourant lesdits canaux, une source et un drain, lesdits canaux étant empilés selon une direction principale z, ledit procédé comprenant les étapes suivantes :
- Fournir sur un substrat un empilement selon la direction principale z comprenant une pluralité de premières couches en un premier matériau alternées avec une pluralité de deuxièmes couches en un deuxième matériau, les premier et deuxième matériaux étant différents dudit matériau semiconducteur formant chaque canal,
- Former dans cet empilement des premières ouvertures définissant des premiers motifs,
- Former une grille sacrificielle à cheval sur les premiers motifs et en partie dans les premières ouvertures,
- Former des premiers espaceurs sur les premiers motifs et bordant la grille sacrificielle,
- Former dans les premiers motifs des deuxièmes ouvertures définissant des deuxièmes motifs,
- Retirer partiellement, à partir des deuxièmes ouvertures, le premier matériau des premières couches sélectivement au deuxième matériau des deuxièmes couches, de sorte à former des premiers espaces à l'aplomb des premiers espaceurs,
- Remplir les premiers espaces par un matériau diélectrique pour former des espaceurs internes,
- Retirer totalement, à partir des deuxièmes ouvertures, le deuxième matériau des deuxièmes couches sélectivement au premier matériau des premières couches, de sorte à former des deuxièmes espaces et à exposer des parties de la grille sacrificielle,
- Former une couche diélectrique, dite couche diélectrique de grille, dans les deuxièmes espaces, sur les parties exposées de la grille sacrificielle et des parties restantes des premières couches, à l'aplomb de la grille sacrificielle,
- Déposer une couche à base d'un matériau semiconducteur dans les deuxièmes espaces, sur la couche diélectrique de grille, à l'aplomb de la grille sacrificielle et des premiers espaceurs, de sorte à former :
   ∘ des canaux à base du matériau semiconducteur à l'aplomb de la grille sacrificielle, et
   ∘ une source et un drain à base du matériau semiconducteur à l'aplomb des premiers espaceurs,
- Former de préférence des contacts de source et drain dans les deuxièmes ouvertures,
- Retirer la grille sacrificielle de sorte à former des troisièmes ouvertures,
- Retirer totalement, à partir des troisièmes ouvertures, le premier matériau des parties restantes des premières couches, de sorte à former des troisièmes espaces entourant les canaux à base du matériau semiconducteur,
- Remplir par un matériau, dit matériau de grille, les troisièmes espaces, de façon à former une grille dite enrobante entourant totalement les canaux de l'au moins un transistor.

Un principe du procédé selon l'invention consiste à remplacer sélectivement certaines couches de l'empilement initial par un matériau semiconducteur afin de former les canaux du transistor. L'empilement initial ne comprend pas le matériau semiconducteur. Le dépôt ultérieur du matériau semiconducteur vise à mieux préserver le matériau semiconducteur. Selon une possibilité préférée, le matériau semiconducteur est un matériau bidimensionnel (2D) choisi parmi les dichalcogénures de métaux de transition MX2 avec M pris parmi le molybdène (Mo) ou le tungstène (W), et X pris parmi le soufre (S) ou le sélénium (Se).

Ainsi, contrairement aux procédés connus qui envisagent la formation de couches à base de matériau 2D dans l'empilement initial, dès le début du procédé, le procédé selon l'invention permet d'introduire des couches de matériau 2D en fin de procédé, après structuration de l'empilement et notamment après la formation des espaceurs internes. Cela permet avantageusement de limiter le risque de dégradation du matériau 2D au cours du procédé. Le matériau 2D n'est pas exposé à toutes les étapes du procédé de fabrication. Le matériau 2D est ainsi préservé.

Par ailleurs, les couches de matériau 2D ne sont pas librement suspendues au cours du procédé selon l'invention. La couche diélectrique de grille enrobe et maintient les parties de matériau 2D autour desquelles la grille enrobante est formée. La tenue mécanique est améliorée. L'intégrité de la structure est ainsi préservée.

En outre, l'introduction tardive du matériau 2D au cours du procédé de fabrication permet d'utiliser les technologies standard de la microélectronique pour la formation et la structuration de l'empilement. Il n'est pas nécessaire de modifier ou d'adapter les étapes technologiques standard de structuration aux contraintes d'utilisation du matériau 2D. Les coûts du procédé sont ainsi avantageusement limités. Le procédé peut en outre être plus facilement implémenté dans des lignes de production existantes.

Les autres objets, caractéristiques et avantages de la présente invention apparaîtront à l'examen de la description suivante et des dessins d'accompagnement. Il est entendu que d'autres avantages peuvent être incorporés.

### BREVE DESCRIPTION DES FIGURES

Les figures nA (n=1... 16) illustrent schématiquement selon des coupes transverses xz des étapes de fabrication d'un dispositif à transistors superposés, selon des modes de réalisation de la présente invention.
Les figures nB (n=1... 16) illustrent schématiquement selon des coupes transverses yz indiquées sur les figures nA correspondantes, les mêmes étapes de fabrication du dispositif, selon des modes de réalisation de la présente invention.

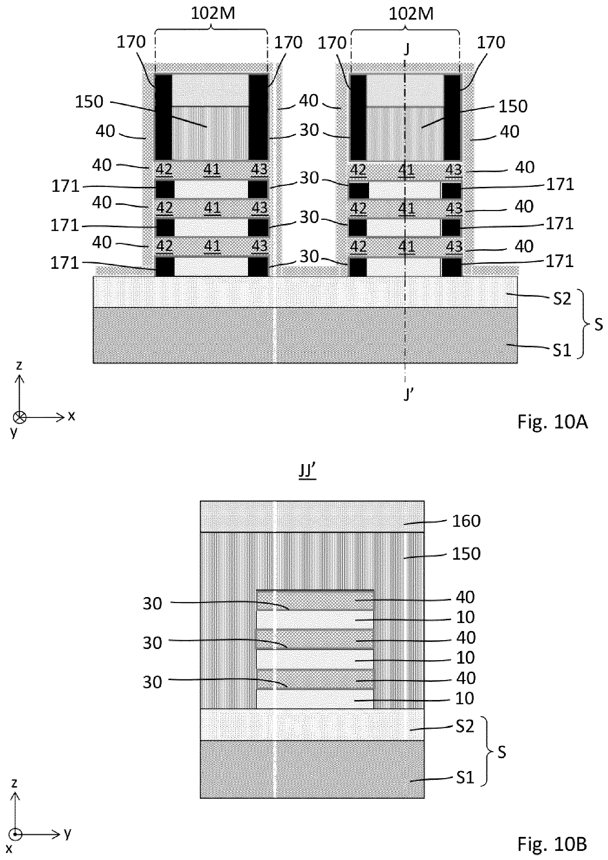

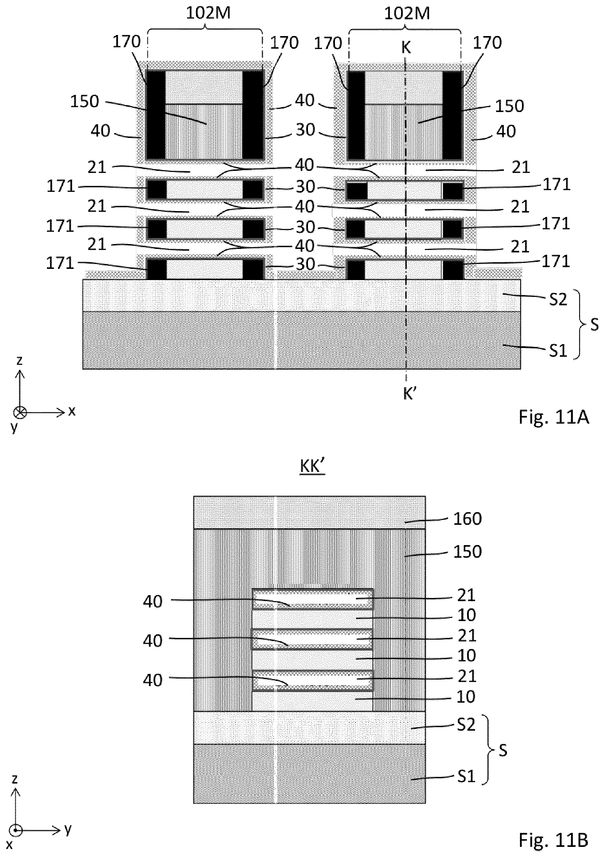

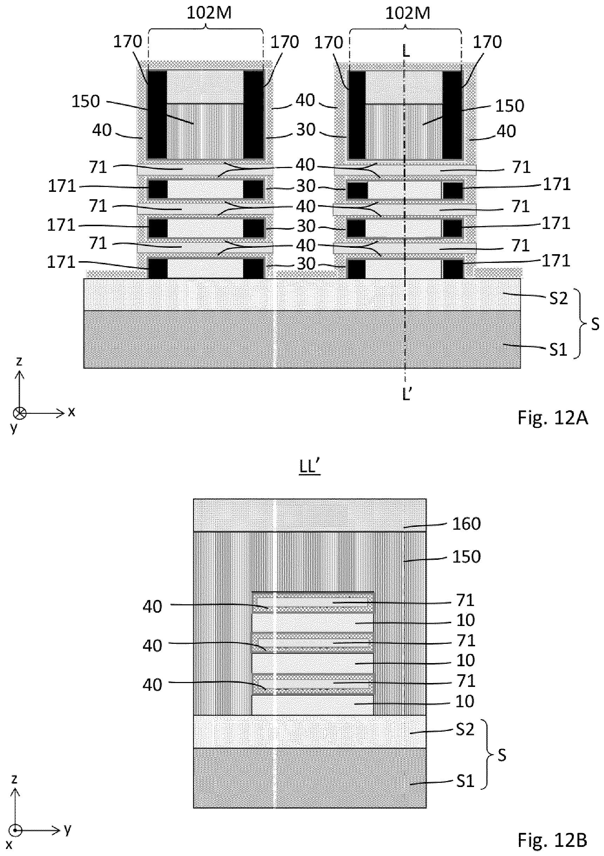

Les figures 11A, 12A et 11B, 12B illustrent notamment des étapes alternatives à l'étape illustrée aux figures 10A, 10B.

Sur les figures en coupes transverses, des plans de coupe sont indiqués (A-A', B-B', ..., P-P') avec des références croisées aux plans de coupe des figures correspondantes. Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, sur les schémas de principe, les épaisseurs et/ou les dimensions des différentes couches, motifs et reliefs ne sont pas représentatives de la réalité. Pour des raisons de clarté, l'ensemble des références alphanumériques n'est pas systématiquement repris d'une figure à l'autre. Il est entendu que les éléments déjà décrits et référencés, lorsqu'ils sont reproduits sur une autre figure, portent typiquement les mêmes références alphanumériques, même si celles-ci ne sont pas explicitement mentionnées. L'homme du métier identifiera sans difficultés un même élément reproduit sur différentes figures.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
Selon un exemple, l'empilement comprend une alternance d'une première couche avec une deuxième couche. De préférence, ladite première couche et ladite deuxième couche sont en contact. Selon un exemple, le dispositif final obtenu par le procédé revendiqué comprend des canaux de transistors formés après retrait sélectif des deuxièmes couches de l'empilement initial. Selon un exemple, le dispositif final comprend des grilles enrobantes formées après retrait sélectif des premières couches de l'empilement initial. L'empilement initial ne comprend typiquement ni le matériau semiconducteur des canaux de transistors, ni le matériau des grilles enrobantes. Selon une possibilité alternative, les canaux de transistors sont formés après retrait sélectif des premières couches de l'empilement initial et les grilles enrobantes sont formées après retrait sélectif des deuxièmes couches de l'empilement initial.

Selon un exemple, les espaceurs internes sont à base de nitrure de silicium. Les espaceurs internes sont de préférence au contact des parties restantes des premières couches. Avant formation des espaceurs internes, le retrait partiel du premier matériau des premières couches est configuré pour conserver des parties des premières couches entre les premiers espaces. Ces parties sont appelées parties restantes. Les parties restantes des premières couches sont ainsi situées entre les premiers espaces, selon une direction du plan xy.

Le dépôt de la couche à base du matériau semiconducteur se fait dans les deuxièmes espaces, entre les parties restantes des premières couches et la grille sacrificielle, selon la direction principale z. Selon un exemple, le dépôt de la couche à base du matériau semiconducteur se fait également sur des flancs du deuxième motif sensiblement parallèles à la direction principale z, en particulier sur des flancs des premiers espaceurs et sur des flancs des espaceurs internes. Cela permet de faciliter la reprise des contacts de source et drain dans le dispositif.

Selon un exemple, le dépôt de la couche à base du matériau semiconducteur est configuré pour former des portions latérales de couche à base du matériau semiconducteur sur des flancs du deuxième motif sensiblement parallèles à la direction principale z, et des portions horizontales de couche à base du matériau semiconducteur dans les deuxièmes espaces, tel que les portions latérales soient plus épaisses que les portions horizontales. Des portions latérales plus épaisses permettent de diminuer la résistance de contact des contacts source et drain. Les canaux du transistor sont formés dans les portions horizontales.

Selon un exemple, le dépôt de la couche à base du matériau semiconducteur est configuré pour former des portions latérales de couche à base du matériau semiconducteur sur les premiers espaceurs et sur les espaceurs internes.

Selon un exemple, le procédé comprend une formation de contacts de source et drain dans les deuxièmes ouvertures.

Selon l'invention la formation des grilles enrobantes est effectuée après le dépôt de la couche à base du matériau semiconducteur. Ce type de procédé, typiquement appelé « gate last » où la grille fonctionnelle est formée en fin de procédé, en remplacement d'une grille sacrificielle, permet de préserver les caractéristiques dimensionnelles de la grille. Cela permet d'obtenir un meilleur contrôle de la tension de seuil des transistors MOSFET. Le budget thermique lié au dépôt du matériau semiconducteur n'impacte pas l'épaisseur équivalente d'oxyde de grille à l'interface avec la grille. Les caractéristiques structurelles et électriques de la grille fonctionnelle sont mieux contrôlées.

Selon un exemple, le dépôt de la couche à base du matériau semiconducteur est effectué par dépôt chimique en phase vapeur ou par dépôt en couche atomique. Les dépôts chimiques en phase vapeur sont faciles à mettre en oeuvre. Les dépôts en couche atomiques permettent de contrôler précisément l'épaisseur de la couche à base du matériau semiconducteur. Ces dépôts permettent d'obtenir une très bonne conformité pour la couche à base du matériau semiconducteur.

Selon un exemple, le matériau semiconducteur est choisi parmi les dichalcogénures de métaux de transition MX2 avec M pris parmi le molybdène (Mo) ou le tungstène (W), et X pris parmi le soufre (S), le sélénium (Se) ou le tellure (Te).

Selon un autre exemple, le matériau semiconducteur est choisi à base d'un oxyde semiconducteur, par exemple à base d'IGZO (Oxyde de zinc-indium-gallium), d'In2O3, d'IWO (Oxyde d'indium dopé au tungstène), d'ITO (L'oxyde d'étain-indium), d'IAZO (Oxyde de zinc-indium -aluminium), d'InGaZnO, d'InGaO, d'InZnO ou d'un oxyde semiconducteur amorphe.

Selon un exemple, le premier matériau est choisi en SiGe et le deuxième matériau est choisi en Si, ou inversement. Ces matériaux peuvent être facilement épitaxiés par des procédés technologiques classiques de la microélectronique. Cela permet de bénéficier des voies technologiques existantes. Le coût du procédé est réduit.

Selon un exemple, la formation de la grille sacrificielle est effectuée de manière à ce que la grille sacrificielle s'étend sur toute une hauteur des premières ouvertures. Selon un exemple, les premières ouvertures s'étendent selon toute la hauteur de l'empilement des premières et deuxièmes couches. La grille sacrificielle s'étend sur toute la hauteur de l'empilement. La grille sacrificielle prend typiquement appui sur le substrat. Cela permet de donner un accès à toutes les couches de l'empilement via les troisièmes ouvertures.

Selon un exemple, les deuxièmes motifs comprennent chacun une partie centrale à l'aplomb de la grille sacrificielle et des première et deuxième parties périphériques de part et d'autre de la partie centrale, à l'aplomb des premiers espaceurs.

Selon un exemple, le dépôt de la couche à base du matériau semiconducteur est configuré pour que la couche à base du matériau semiconducteur remplisse totalement les deuxièmes espaces.

Selon un autre exemple, le dépôt de la couche à base du matériau semiconducteur est configuré pour que la couche à base du matériau semiconducteur remplisse partiellement les deuxièmes espaces. Selon un exemple, le procédé comprend en outre, après dépôt de la couche à base du matériau semiconducteur, un dépôt d'une couche diélectrique configuré pour combler les deuxièmes espaces. Cela permet de former une couche à base du matériau semiconducteur de faible épaisseur, sans contrainte sur l'épaisseur des deuxièmes couches de l'empilement. La couche à base du matériau semiconducteur peut présenter une épaisseur inférieure à celle des deuxièmes couches de l'empilement initial.

Selon un exemple, le substrat est un substrat massif à base de silicium.

Selon un exemple, l'empilement comprend au moins trois premières couches du premier matériau alternées avec trois deuxièmes couches du deuxième matériau.

Selon un exemple, l'empilement comprend autant de premières couches du premier matériau que de deuxièmes couches du deuxième matériau.

Selon un exemple, les premières ouvertures sont formées selon une direction longitudinale x et les deuxièmes ouvertures sont formées selon une direction transversale y perpendiculaire à la direction longitudinale x, lesdites premières et deuxièmes ouvertures s'étendant jusqu'au substrat.

Selon un exemple, le retrait du premier matériau des premières couches sélectivement au deuxième matériau des deuxièmes couches est effectué par une première gravure sélective présentant une sélectivité S_{10:20} d'au moins 5:1, de préférence au moins 10:1. Cette première gravure sélective est typiquement arrêtée au temps.

Selon un exemple, le retrait du deuxième matériau des deuxièmes couches sélectivement au premier matériau des premières couches est effectué par une deuxième gravure sélective présentant une sélectivité S_{20:10} d'au moins 5:1, de préférence au moins 10:1.

Selon un exemple, le dépôt de la couche à base du matériau semiconducteur est configuré pour former des portions latérales de couche à base du matériau semiconducteur sur des flancs du deuxième motif dans les deuxièmes ouvertures. Selon un exemple, le procédé comprend en outre une formation de contacts de source et drain dans lesdites deuxièmes ouvertures et sur les portions latérales de couche à base du matériau semiconducteur, avant le retrait de la grille sacrificielle.

Sauf incompatibilité, il est entendu que l'ensemble des caractéristiques optionnelles ci-dessus peuvent être combinées de façon à former un mode de réalisation qui n'est pas nécessairement illustré ou décrit. Un tel mode de réalisation n'est évidemment pas exclu de l'invention. Les caractéristiques et les avantages d'un aspect de l'invention peuvent être adaptés *mutatis mutandis* à l'autre aspect de l'invention.

L'invention porte d'une manière générale sur un procédé de fabrication d'un dispositif microélectronique à transistors GAA. Un tel dispositif microélectronique obtenu par le procédé revendiqué peut présenter une architecture de type « GAA stacked nanosheet », c'est-à-dire à nanofeuilles empilées et grille totalement enrobante. Une architecture à nanofils empilés et grille totalement enrobante est également possible.

Les nanofils ou nanofeuilles comprennent typiquement chacun un canal de conduction d'un transistor. Ces canaux sont empilés selon une direction z. Cela signifie qu'ils occupent chacun un niveau d'altitude donnée selon la direction z. Un niveau peut être défini entre deux plans perpendiculaires à la direction z.

De manière avantageuse, le procédé selon l'invention peut être mis en oeuvre pour la réalisation de transistors MOS GAA pour les nœuds technologiques 5 nm et sub-5 nm.

Un dispositif microélectronique obtenu par le procédé revendiqué comprenant des transistors GAA superposés peut être avantageusement intégré dans des systèmes logiques présentant des architectures 3D. Ces transistors peuvent notamment être associés à d'autres éléments structuraux ou fonctionnels de façon à concevoir des systèmes complexes.

Un aspect particulier de l'invention concerne la mise en œuvre de matériaux 2D pour réaliser les nanofils ou nanofeuilles du dispositif.

Les matériaux 2D correspondent typiquement à des composés présentant une structure lamellaire constituée de feuillets bidimensionnels, empilés selon l'axe cristallographique c. Les liaisons atomiques au sein de chaque feuillet sont fortes, de nature covalente. Les liaisons entre feuillets sont beaucoup plus faibles, de type Van der Waals. Ces feuillets bidimensionnels sont également appelés monocouches.

Dans le cadre de la présente invention, les monocouches sont de préférence des monocouches semiconductrices du type MX2 où M est du molybdène (Mo) ou du tungstène (W) et X du soufre (S) ou du sélénium (Se). Chaque « monocouche » est ici composée d'un plan de cations métalliques M inséré entre deux plans d'anions X. Une monocouche comprend donc ici typiquement trois plans atomiques : les atomes du métal de transition (Mo ou W) forment un plan pris en sandwich entre deux plans de chalcogènes (S, Se ou Te, par exemple). Chaque atome de métal de transition est relié à six atomes de chalcogène. Ces anions sont en coordination trigonale prismatique par rapport aux atomes de métal. Les monocouches de dichalcogénures de métaux de transition MX2 présentent un réseau atomique hexagonal.

Les monocouches de dichalcogénures de métaux de transition MX2 sont de préférence à base de disulfure de molybdène MoS2, MoSe2, MoTe2, WS2, WSe2.

Une possibilité alternative concerne la mise en œuvre d'oxydes semiconducteurs pour réaliser les nanofils ou nanofeuilles du dispositif, par exemple IWO, IGZO, ITO, InGaZnO, InGaO, InZnO, In2O3, IAZO. Une autre possibilité concerne la mise en œuvre de graphène, de nitrure de bore hexagonal « h-BN », de phosphorène (également connu sous le nom de « Black Phosphorous » BP), notamment sous forme de monocouche.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt ou l'application d'une première couche sur une deuxième couche, ne signifie pas obligatoirement que les deux couches sont directement au contact l'une de l'autre, mais signifie que la première couche recouvre au moins partiellement la deuxième couche en étant soit directement à son contact, soit en étant séparée d'elle par au moins une autre couche ou au moins un autre élément.

On entend par un substrat, un film, une couche, « à base » d'un matériau A, un substrat, un film, une couche comprenant ce matériau A uniquement ou ce matériau A et éventuellement d'autres matériaux, par exemple des éléments dopants ou des éléments d'alliage. Ainsi, un espaceur à base de nitrure de silicium SiN peut par exemple comprendre du nitrure de silicium non stœchiométrique (SiN), ou du nitrure de silicium stœchiométrique (Si3N4), ou encore un oxy-nitrure de silicium (SiON).

Le mot « diélectrique » qualifie un matériau dont la conductivité électrique est suffisamment faible dans l'application donnée pour servir d'isolant. Dans la présente invention, un matériau diélectrique présente de préférence une constante diélectrique inférieure à 20. Dans la présente invention, la couche diélectrique peut présenter des propriétés ferroélectriques.

Plusieurs modes de réalisation de l'invention mettant en œuvre des étapes successives du procédé de fabrication sont décrits ci-après. Sauf mention explicite, l'adjectif « successif » n'implique pas nécessairement, même si cela est généralement préféré, que les étapes se suivent immédiatement, des étapes intermédiaires pouvant les séparer.

Par ailleurs, le terme « étape » s'entend de la réalisation d'une partie du procédé, et peut désigner un ensemble de sous-étapes.

Par ailleurs, le terme « étape » ne signifie pas obligatoirement que les actions menées durant une étape soient simultanées ou immédiatement successives. Certaines actions d'une première étape peuvent notamment être suivies d'actions liées à une étape différente, et d'autres actions de la première étape peuvent être reprises ensuite. Ainsi, le terme étape ne s'entend pas forcément d'actions unitaires et inséparables dans le temps et dans l'enchaînement des phases du procédé.

On entend par « gravure sélective vis-à-vis de » ou « gravure présentant une sélectivité vis-à-vis de » une gravure configurée pour enlever un matériau A ou une couche A vis-à-vis d'un matériau B ou d'une couche B, et présentant une vitesse de gravure du matériau A supérieure à la vitesse de gravure du matériau B. La sélectivité est le rapport entre la vitesse de gravure du matériau A sur la vitesse de gravure du matériau B. Elle est notée S_{A:B}. Une sélectivité S_{A:B} de 10:1 signifie que la vitesse de gravure du matériau A est 10 fois supérieure à la vitesse de gravure du matériau B.

Les différents motifs formés au cours des étapes de fabrication présentent typiquement une structure destinée à évoluer lors des étapes du procédé. Ainsi, les motifs peuvent comprendre les couches sacrificielles de l'empilement initial, les couches à base de matériau 2D ou d'oxyde semiconducteur, les couches diélectriques, continues ou discontinues. Les différents motifs visent à former, en fin de procédé, des « motifs de transistors » comprenant chacun au moins un canal de conduction et une grille entourant ledit canal, une barrière diélectrique séparant la grille et le canal, une source et un drain de part et d'autre du canal. L'assignation des premières et deuxièmes couches dans l'empilement initial peut être inversée.

Un repère de préférence orthonormé, comprenant les axes x, y, z est représenté sur les figures annexées.

Dans la présente demande de brevet, on parlera préférentiellement d'épaisseur pour une couche ou un film, et de hauteur pour un dispositif ou une structure. L'épaisseur est prise selon une direction normale au plan d'extension principal de la couche ou du film. Ainsi, une couche superficielle de silicium (topSi) présente typiquement une épaisseur selon z. Un motif de grille formé sur une telle couche superficielle présente une hauteur selon z. Les termes relatifs « sur », « surmonte », « sous », « sous-jacent » se réfèrent à des positions prises selon la direction z. Une dimension « latérale » correspond à une dimension selon une direction du plan xy. On entend par une extension « latérale » ou « latéralement », une extension selon une ou des directions du plan xy.

Un élément situé « à l'aplomb » ou « au droit d' » un autre élément signifie que ces deux éléments sont situés tous deux sur une même ligne perpendiculaire à un plan dans lequel s'étend principalement une face inférieure ou supérieure d'un substrat, c'est-à-dire sur une même ligne orientée verticalement sur les figures en coupe transverse.

Les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire.

La description qui suit présente un exemple de mise en oeuvre du procédé selon l'invention dans un contexte d'élaboration d'un dispositif 3D complexe. Le cadre de cette description n'est évidemment pas limitatif de l'invention.

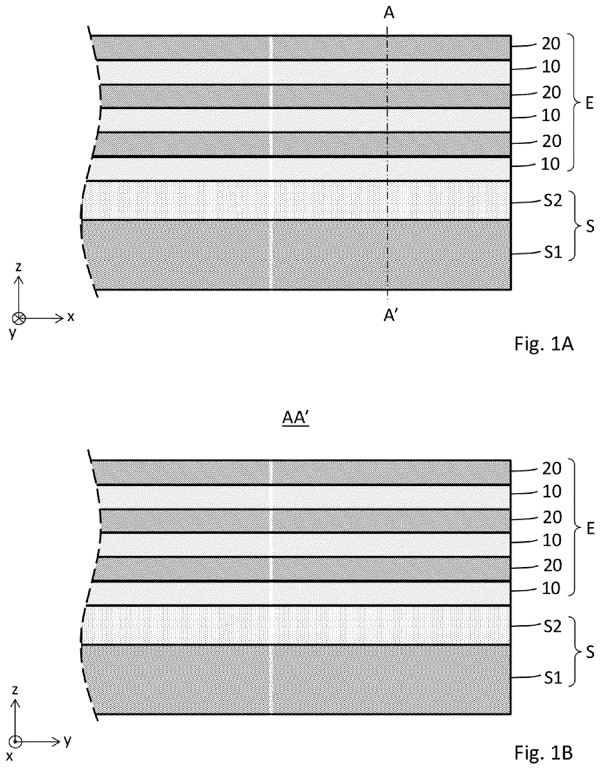

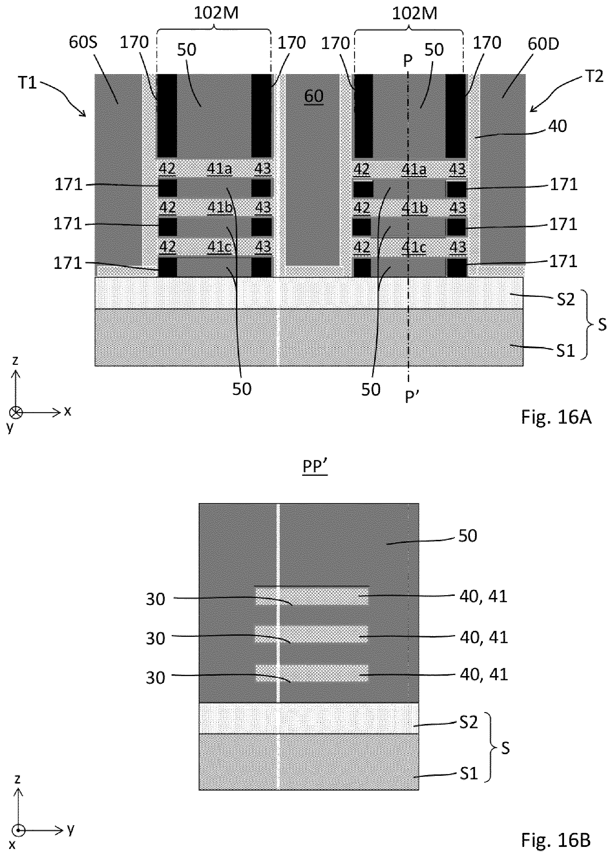

Les figures 1A, 1B à 16A, 16B illustrent schématiquement des étapes de fabrication d'un dispositif comprenant des transistors GAA empilés. Les figures nA (n=1... 16) correspondent à des premières coupes transverses illustrant chacune une étape différente du procédé de fabrication. Les figures nB (n=1...16) correspondent à des deuxièmes coupes transverses illustrant chacune la même étape que la figure nA correspondante.

Comme illustré aux figures 1A, 1B, une première étape consiste à réaliser un empilement E de couches semi-conductrices 10, 20 sur un substrat S. Le substrat S peut être un substrat de type SOI (Silicon On Insulator), GeOI (Germanium On Insulator) ou SGOI (Silicon-Germanium On Insulator). Ces substrats connus comprennent, selon la terminologie courante pour l'homme du métier, une couche S1 de silicium épaisse dite « Si bulk », une couche S2 d'oxyde de silicium dite « BOX » (Burried Oxide) et une couche mince superficielle, respectivement à base de silicium, de germanium ou de silicium-germanium. Cette couche mince superficielle peut avantageusement correspondre à la première couche 10 de l'empilement E.

Alternativement, le substrat S peut être un substrat massif « Si bulk ».

L'empilement E comprend selon un exemple une alternance de premières couches 10 en silicium-germanium (SiGe) et de deuxièmes couches 20 en silicium (Si).

La concentration du Ge dans l'alliage SiGe peut être de 20%, 30% ou 45% par exemple. Cette concentration de germanium est choisie de façon à permettre une bonne sélectivité de la gravure du SiGe par rapport au Si, lors des étapes de gravure sélective. Plus la concentration de Ge sera importante, plus la sélectivité au Si sera grande lors du retrait ultérieur du SiGe. Cet empilement E est avantageusement formé par épitaxie des couches de SiGe 10 et de Si 20. Cette étape de formation de l'empilement E est peu coûteuse et bien connue de l'homme du métier. Les épaisseurs des couches Si et SiGe peuvent être typiquement de l'ordre de 10 nm, et plus généralement comprises entre 5 nm et 20 nm par exemple. De façon connue afin d'éviter la formation de défauts structuraux, les épaisseurs maximales permises pour les couches 10 en SiGe dépendent notamment de la concentration en Ge choisie.

Dans l'exemple illustré aux figures 1A, 1B trois couches 10 de SiGe sont alternées avec trois couches 20 de Si épitaxiées. Un super réseau Si/SiGe est ainsi obtenu. Le nombre de couches de Si et de SiGe peut naturellement être augmenté. Cela permet *in fine* d'augmenter le nombre de transistors empilés dans le dispositif final.

D'une façon générale le premier matériau des premières couches 10 et le deuxième matériau des deuxièmes couches 20 sont choisis de façon à ce que l'un puisse être gravé sélectivement par rapport à l'autre. Ainsi, d'autres couples de premier et deuxième matériaux sont possibles. En respectant cette condition de sélectivité à la gravure, les premier et deuxième matériaux peuvent être choisis parmi les matériaux diélectriques (oxydes et nitrures par exemple), les matériaux semiconducteurs, les matériaux métalliques.

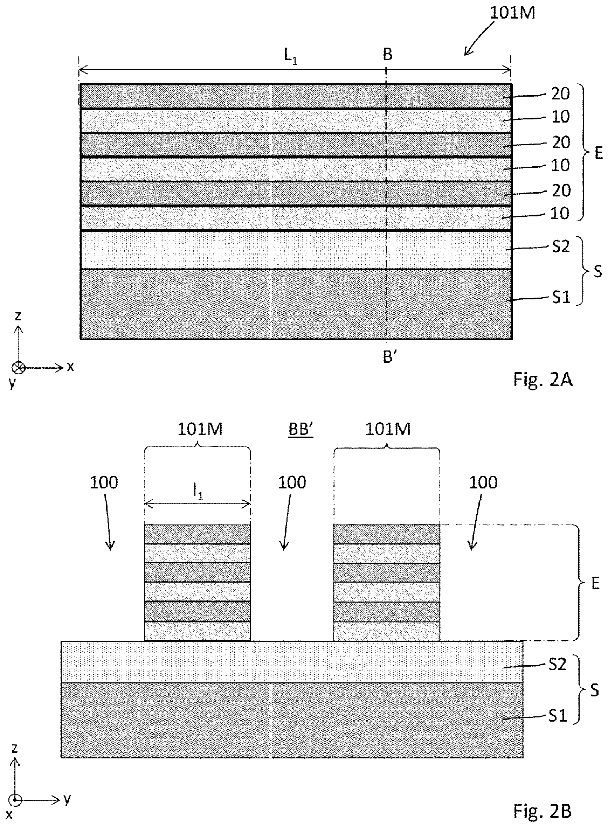

Comme illustré aux figures 2A, 2B, une étape classique de lithographie/gravure est réalisée afin de définir des premiers motifs 101M, et des premières ouvertures 100. La gravure est anisotrope et dirigée selon z. Elle est configurée pour graver l'empilement E, ici le super réseau Si/SiGe, sur toute sa hauteur, en s'arrêtant sur le substrat S, ici le BOX S2. Elle peut être effectuée par plasma en utilisant une chimie de gravure HBr/O2. Les premiers motifs 101M peuvent présenter une longueur L₁ selon x comprise entre 10 nm et 500 nm. Ils présentent de préférence une largeur I₁ selon y comprise entre 10 nm et 120 nm, par exemple de l'ordre de 40 nm. Cette première structuration de l'empilement E sous forme d'ailettes ou « fins » selon la terminologie anglo-saxonne courante, permet de définir une pluralité de nanofils ou de nanosheets superposés.

Par souci de clarté les figures suivantes iB (i=3... 16) n'illustrent qu'un seul motif de « fin » 101M.

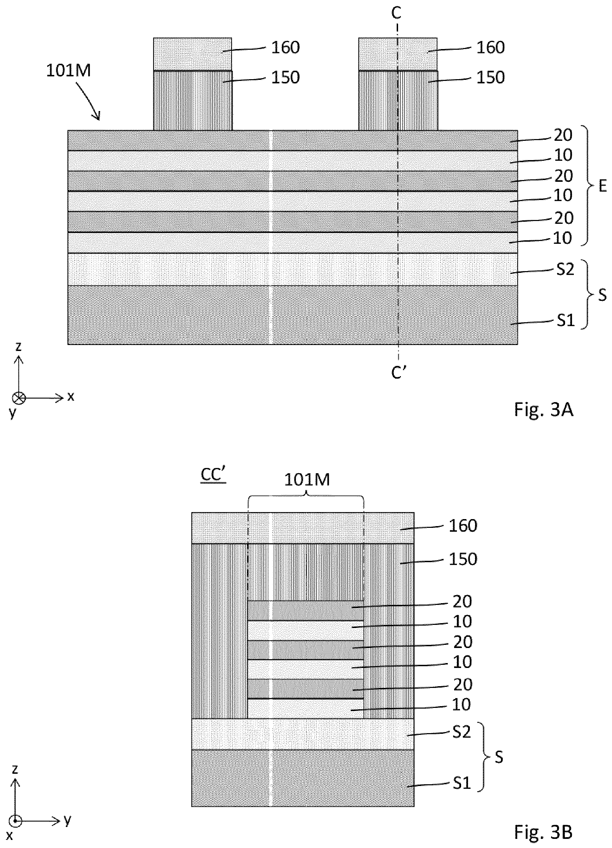

Comme illustré aux figures 3A, 3B, des grilles sacrificielles 150 sont ensuite formées sur les motifs de « fin » 101M. La formation de ces grilles sacrificielles 150 se fait typiquement par lithographie/gravure. La formation des grilles sacrificielles 150 est configurée de sorte que les grilles sacrificielles 150 soient à cheval sur les motifs de « fin » 101M, comme illustré en figure 3B. Les grilles sacrificielles 150 comprennent typiquement une partie supérieure située sur le motif de « fin » 101M, et des parties latérales situées sur les flancs latéraux du motif de « fin » 101M. Les grilles sacrificielles 150 prennent typiquement appui sur le substrat S. A ce stade, les grilles sacrificielles 150 sont typiquement surmontées par un masque de gravure 160, dit masque dur, mis en œuvre dans la structuration des grilles sacrificielles 150. Les grilles sacrificielles 150 sont par exemple à base de silicium polycristallin. Une fine couche d'oxyde SiO₂, d'épaisseur 7 nm par exemple, est de préférence déposée préalablement à la formation des grilles sacrificielles 150. Cette fine couche d'oxyde SiO₂ (non illustrée sur les figures) est ainsi intercalée entre les grilles sacrificielles 150 et les motifs de « fin » 101M. Cette fine couche d'oxyde SiO₂ peut former une couche d'arrêt pour la gravure ultérieure des grilles sacrificielles 150.

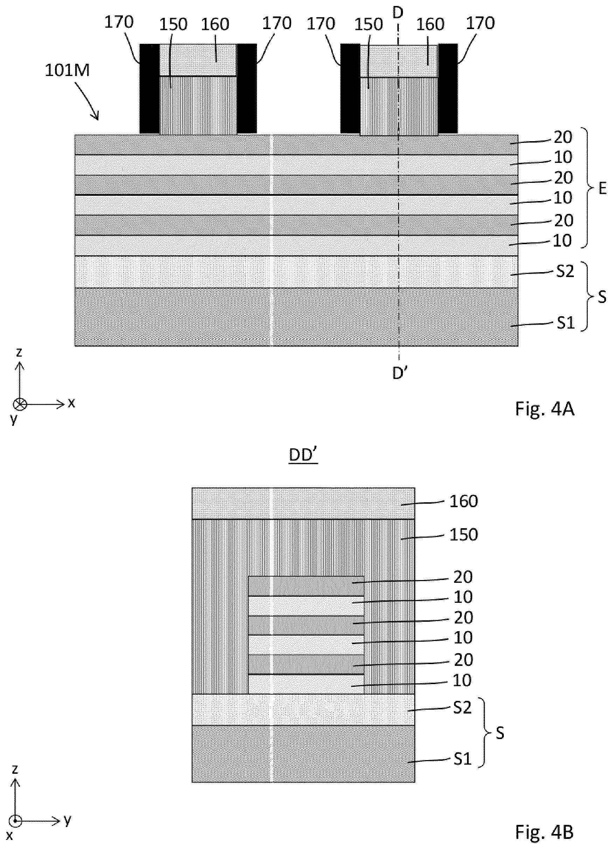

Comme illustré aux figures 4A, 4B, des premiers espaceurs 170 sont ensuite formés sur les flancs orientés selon yz des grilles sacrificielles 150. En général, en projection selon z, ces espaceurs forment une bague continue autour de chaque grille sacrificielle 150, avec un contour fermé. En coupe transverse cependant, selon le plan xz illustré à la figure 4A, le premier espaceur 170 présente deux parties en vis-à-vis sur chacun des flancs de la grille sacrificielle 150. Ces deux parties sont généralement désignées comme étant les premiers espaceurs 170, même si celles-ci peuvent être considérées comme appartenant à un seul et même espaceur. Les premiers espaceurs 170 s'étendent typiquement jusqu'à une face supérieure des masques durs 160. Les premiers espaceurs 170 sont typiquement à base de nitrure de silicium SiN ou d'un matériau diélectrique à faible constante diélectrique, par exemple à base de SiCO.

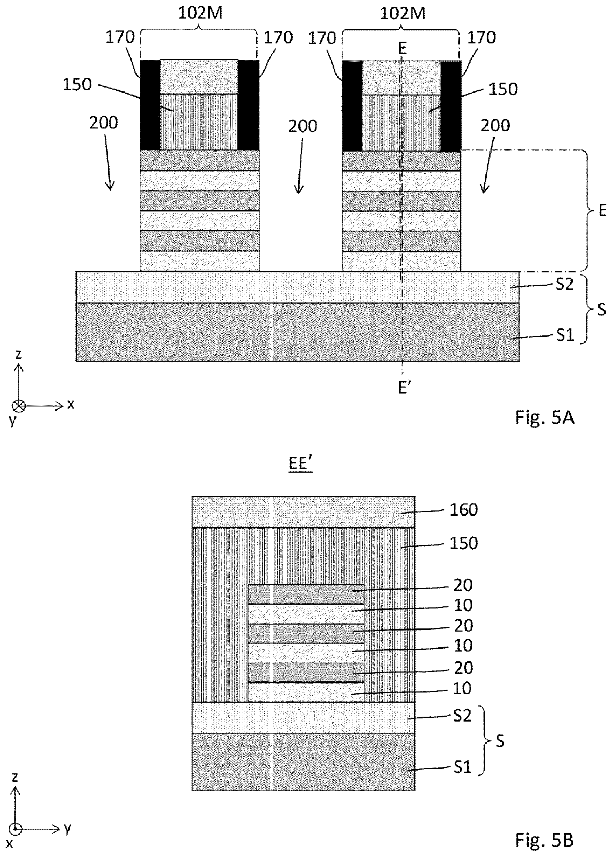

Comme illustré aux figures 5A, 5B, après formation des premiers espaceurs 170 par dépôt/gravure, la gravure anisotrope selon z est prolongée afin de définir des deuxièmes motifs 102M, et des deuxièmes ouvertures 200. La gravure est configurée pour graver l'empilement E sur toute sa hauteur, en s'arrêtant sur le substrat S. Elle peut être effectuée par plasma en utilisant une chimie de gravure HBr/O2.

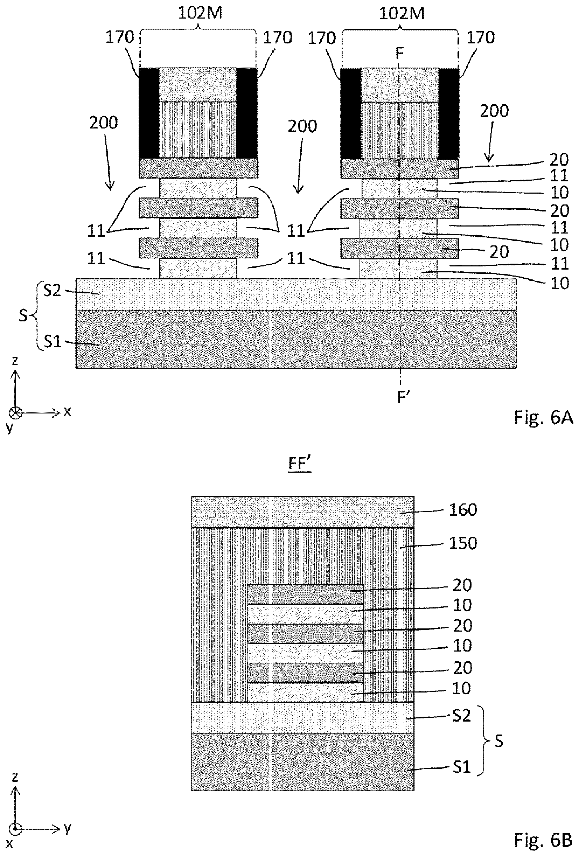

Comme illustré aux figures 6A, 6B, après formation des deuxièmes ouvertures 200, les premières couches 10 sont partiellement gravées sélectivement aux deuxièmes couches 20, au substrat S et aux premiers espaceurs 170. La gravure du premier matériau des premières couches 10 présente typiquement une sélectivité S_{10:20} par rapport au deuxième matériau des deuxièmes couches 20, d'au moins 5:1, de préférence au moins 10:1. Cette gravure partielle vise à former des premiers espaces 11 à l'aplomb des premiers espaceurs 170. Cette gravure partielle est typiquement arrêtée au temps. Elle présente un caractère isotrope et peut être effectuée par voie humide ou par voie sèche, à partir des deuxièmes ouvertures 200. A l'issue de cette gravure partielle, des parties centrales des premières couches 10 sont conservées sous les grilles sacrificielles 150.

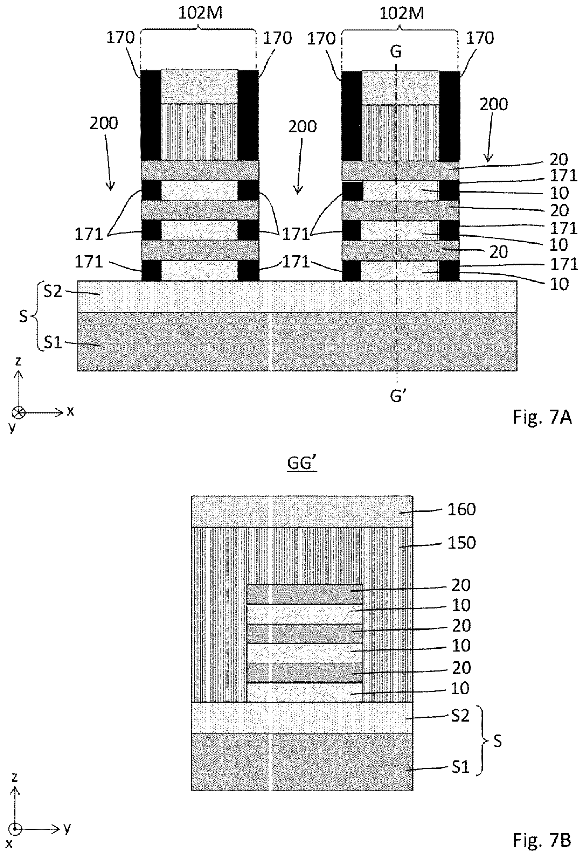

Comme illustré aux figures 7A, 7B, les premiers espaces 11 sont ensuite remplis par un matériau diélectrique, par exemple par du nitrure de silicium ou par un diélectrique à faible permittivité, pour former des espaceurs internes 171. Ces espaceurs « internes » 171 sont intégrés dans l'empilement E, de préférence à l'aplomb des premiers espaceurs 170. Ils sont au contact des parties centrales des premières couches 10. La formation des espaceurs internes 171 se fait typiquement à partir des deuxièmes ouvertures 200.

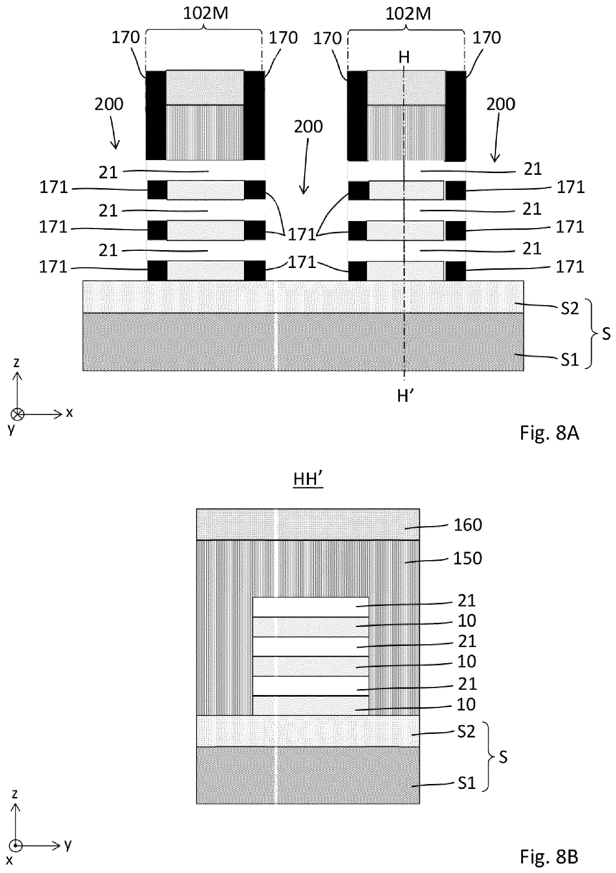

Comme illustré aux figures 8A, 8B, les deuxièmes couches 20 sont ensuite gravées sélectivement aux parties centrales des premières couches 10 et aux espaceurs internes 171. La gravure du deuxième matériau des deuxièmes couches 20 présente typiquement une sélectivité S_{20:10} par rapport au premier matériau des premières couches 10, d'au moins 5:1, de préférence au moins 10:1. Cette gravure totale peut être arrêtée au temps, possiblement après un temps de surgravure visant à garantir le retrait total du deuxième matériau des deuxièmes couches 20. Cette gravure totale présente un caractère isotrope et peut être effectuée par voie humide ou par voie sèche, à partir des deuxièmes ouvertures 200. A l'issue de cette gravure, les deuxièmes couches 20 sont retirées totalement pour former des deuxièmes espaces 21. Les parties centrales des premières couches 10 sont maintenues par les grilles sacrificielles 150, comme illustré à la figure 8B.

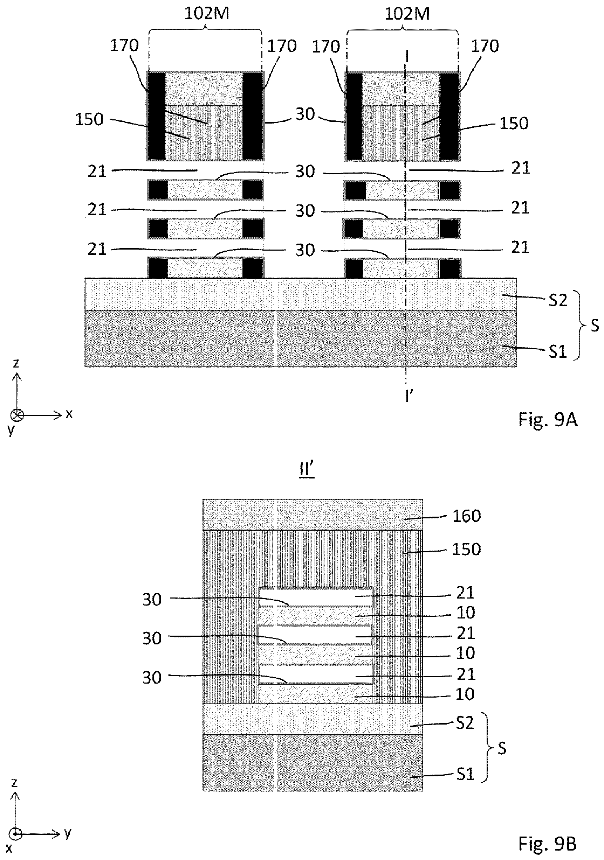

Comme illustré aux figures 9A, 9B, une couche diélectrique 30 est ensuite déposée dans les deuxièmes espaces 21. Cette couche diélectrique 30 est typiquement à base d'un matériau à forte permittivité, par exemple à base de HfO2. La couche diélectrique 30 est destinée à former la couche diélectrique de grille entre les canaux des transistors GAA et leurs grilles enrobantes. Elle peut être formée par dépôt chimique en phase vapeur CVD (acronyme de « Chemical Vapor Deposition »), par dépôt chimique en phase vapeur à précurseurs organométalliques MOCVD (acronyme de « Metal Organic Chemical Vapor Deposition ») ou par dépôt en couche atomique ALD (acronyme de « Atomic Layer Deposition »). Elle recouvre ainsi au moins les parties centrales des premières couches 10 et la face inférieure exposée de la grille sacrificielle 150, et de préférence les espaceurs internes 171, et les premiers espaceurs 170. La couche diélectrique 30 présente typiquement une épaisseur comprise entre 1 nm et 5 nm. Selon un exemple alternatif, cette couche 30 peut être à base d'un matériau ferroélectrique tel que HfZrO2, HZO, HfO2 dopé Si par exemple. Une telle couche ferroélectrique 30 peut être avantageusement employée pour la réalisation de transistors mémoires de type FeFET (acronyme de « ferroelectric field-effect transistor » en français « transistor à effet de champ ferroélectrique »).

Comme illustré aux figures 10A, 10B, selon un premier mode de réalisation, une couche 40 à base d'un matériau semiconducteur est ensuite déposée sur la couche diélectrique 30 de grille dans les deuxièmes espaces 21. Le dépôt du matériau semiconducteur est ici configuré pour que la couche 40 remplisse totalement les deuxièmes espaces 21. Les portions de la couche 40 situées dans les deuxièmes espaces 21 présentent ainsi une épaisseur parfaitement contrôlée, proche de l'épaisseur des deuxièmes couches initiales. Cette couche 40 est destinée à former les canaux 41 des transistors GAA à l'aplomb des grilles sacrificielles 150 et des parties centrales des premières couches 10. Cette couche 40 est également destinée à former les sources 42 et les drains 43 des transistors GAA à l'aplomb des premiers espaceurs 170 et des espaceurs internes 171.

La couche 40 est également typiquement déposée en dehors des deuxièmes espaces 21, sur les flancs des premiers espaceurs 170 et des espaceurs internes 171. Cela permet d'améliorer la reprise de contact avec les sources 42 et les drains 43 des transistors GAA. La couche 40 présente ainsi des portions horizontales dans les deuxièmes espaces 21, notamment entre les parties restantes des premières couches, et des portions verticales sur les flancs des premiers espaceurs 170 et des espaceurs internes 171. Selon une possibilité, l'épaisseur des portions verticales de la couche 40 est plus importante que l'épaisseur des portions horizontales de la couche 40. Cela permet de réduire la résistance de contact pour les sources 42 et les drains 43 des transistors GAA. Les sources 42 et les drains 43 des transistors GAA peuvent comprendre les portions horizontales à l'aplomb des premiers espaceurs 170 et des espaceurs internes 171, et au moins en partie les portions verticales sur les flancs des premiers espaceurs 170 et des espaceurs internes 171.

Le matériau semiconducteur de la couche 40 est avantageusement un matériau bidimensionnel pris parmi les dichalcogénures de métaux de transition MX2 avec M le molybdène (Mo) ou le tungstène (W), et X le soufre (S), le sélénium (Se) ou le tellure (Te). Un tel matériau 2D peut être avantageusement déposé sous forme de couche mince comprenant 1 à 10 couches atomiques, de préférence 1 à 5 couches atomiques. Le dépôt de ce matériau 2D peut se faire par CVD, MOCVD ou ALD. Selon une autre possibilité, le matériau semiconducteur de la couche 40 est un oxyde semiconducteur tel que l'ITO (acronyme de « Oxyde d'étain-indium»), l'IGZO (acronyme de « Oxyde de zinc-indium-gallium »), l'IWO (signifiant « oxyde d'indium dopé au tungstène»), l'oxyde d'indium In2O3. Selon une autre possibilité, le matériau semiconducteur de la couche 40 est un graphène, un nitrure de bore hexagonal « h-BN », un phosphorène (également connu sous le nom de « Black Phosphorous » BP), sous forme de monocouche ou de couche mince comprenant 1 à 10 couches atomiques, de préférence 1 à 5 couches atomiques.

Comme illustré aux figures 11A, 11B, selon un deuxième mode de réalisation, la couche 40 à base du matériau semiconducteur est déposée sur la couche diélectrique 30 de grille dans les deuxièmes espaces 21 sans remplir totalement les deuxièmes espaces 21. Dans ce cas, les portions de la couche 40 situées dans les deuxièmes espaces 21 peuvent être significativement plus minces que les deuxièmes couches initiales. Ces portions horizontales peuvent présenter une épaisseur correspondant à quelques couches atomiques seulement, par exemple entre 1 et 5 couches atomiques de matériau semiconducteur. La réduction d'épaisseur de la couche 40 permet d'améliorer le contrôle électrostatique des transistors et donc de réduire les dimensions des canaux 41 des transistors GAA. Les performances des transistors GAA peuvent être améliorées.

Selon ce deuxième mode de réalisation, comme illustré aux figures 12A, 12B, un bouchon diélectrique 71 est ensuite formé entre les portions horizontales de la couche 40, afin de remplir les deuxièmes espaces 21. Cela permet d'isoler électriquement les transistors GAA entre eux. Cela permet également d'améliorer la résistance mécanique du dispositif e/ou d'éviter des déformations des canaux des transistors GAA, par exemple par échauffement lors du fonctionnement. Ce bouchon diélectrique 71 peut être formé par un dépôt CVD ou ALD suivi d'une gravure isotrope selon z, de façon classique.

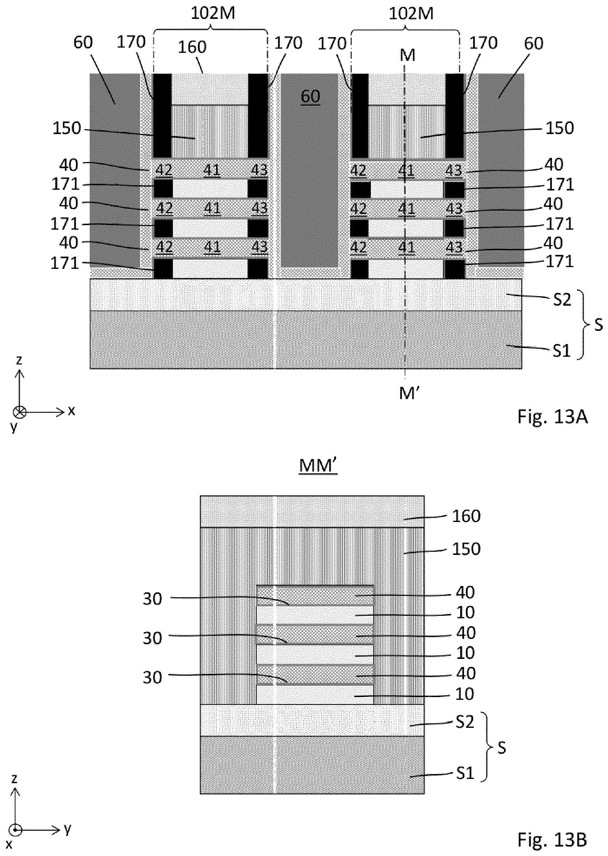

Comme illustré aux figures 13A, 13B, les deuxièmes ouvertures peuvent ensuite être remplies par une ou plusieurs couches métalliques 60, par exemple à base de Ti, TiN, W, ou par d'autres métaux permettant d'assurer une faible résistance de contact tels que Bi, Ni, Au, Sb, etc., afin de former les contacts de source et drain. Un polissage mécano-chimique CMP est typiquement effectué afin de retirer l'excès de métal déposé sur les motifs 102M. Les masques durs 160 sont ainsi exposés.

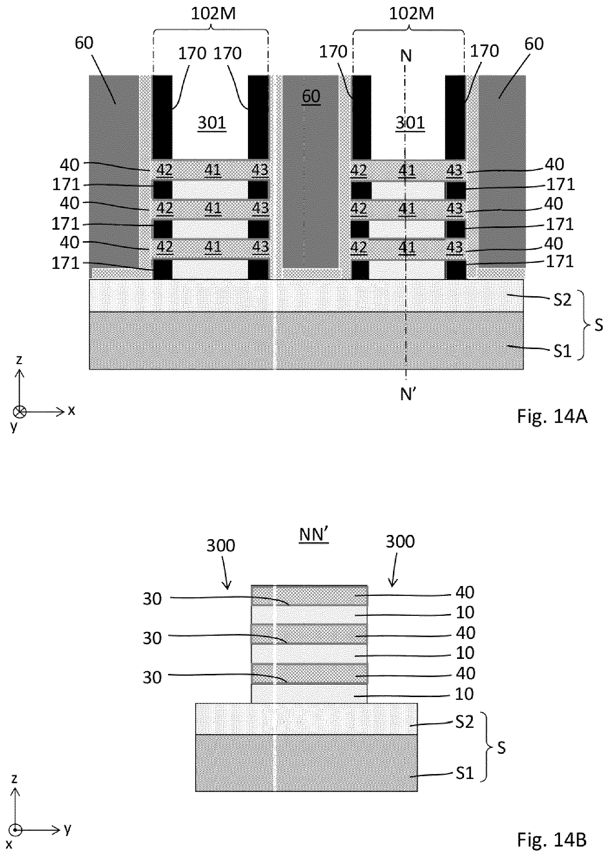

Comme illustré aux figures 14A, 14B, les masques durs 160 sont d'abord retirés, puis les grilles sacrificielles 150 sont également retirées. Ce retrait peut être effectué par gravure humide avec arrêt sur la fine couche d'arrêt à base de SiO2 ou d'un autre diélectrique. La couche diélectrique 30 est préservée. Cette gravure humide présente typiquement une sélectivité élevée vis-à-vis de la couche d'arrêt et des premiers espaceurs 170. Cette gravure humide peut être à base d'une solution de sels d'ammoniaque TMAH (Hydroxyde de tétraméthylammonium) ou TEAH (Hydroxyde de tétraéthylammonium). La couche d'arrêt à base de SiO2 est ensuite typiquement gravée par voie humide pour exposer la couche diélectrique 30. Ce retrait des grilles sacrificielles 150 permet de former un espace principal 301 et des troisièmes ouvertures 300 débouchant sur les parties centrales des premières couches 10 (figure 14B).

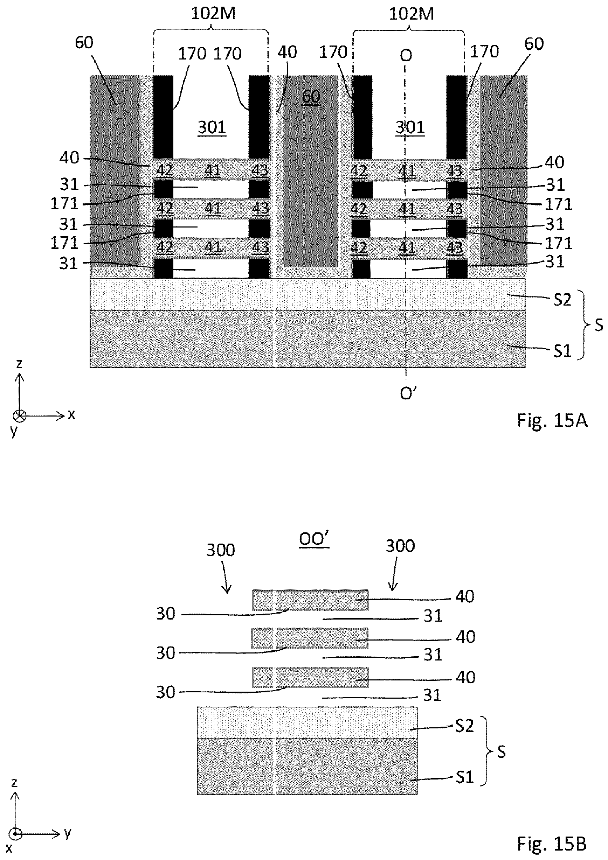

Comme illustré aux figures 15A, 15B, les parties centrales des premières couches 10 sont ensuite totalement retirées par gravure sélective vis-à-vis de la couche diélectrique 30, à partir des troisièmes ouvertures 300. Cette gravure vise à former des troisièmes espaces 31 à la place des parties centrales des premières couches 10. Cette gravure présente un caractère isotrope et peut être effectuée par voie humide ou par voie sèche, à partir des troisièmes ouvertures 300.

Comme illustré aux figures 16A, 16B, les espaces principaux 301 et les troisièmes espaces 31 sont ensuite remplis par une ou plusieurs couches métalliques 50, par exemple à base de TiN, W, afin de former les grilles enrobantes des transistors GAA. Selon une possibilité, avant dépôt des couches métalliques 50, une couche diélectrique à base d'un matériau à forte permittivité, par exemple à base de HfO2, est préalablement déposée dans les espaces principaux 301 et les troisièmes espaces 31. Cela permet d'augmenter l'épaisseur de la couche diélectrique de grille entre les canaux 41 des transistors GAA et leurs grilles 50 enrobantes. Un polissage mécano-chimique CMP est typiquement effectué afin de retirer l'excès de métal déposé sur les motifs 102M.

Un dispositif microélectronique comprenant trois transistors T1, T2, T3 empilés selon z, à grille enrobante 50, est ainsi avantageusement obtenu. Les canaux 41, les sources 42 et les drains 43 sont de préférence à base d'un matériau bidimensionnel. Des contacts de source et drain 60S, 60, 60D viennent connecter électriquement ces transistors GAA T1, T2, T3 empilés selon z.

Au vu de la description qui précède, il apparaît clairement que le procédé proposé offre une solution particulièrement efficace pour former des transistors GAA empilés à base de matériau 2D. Cette solution est en outre avantageusement compatible avec les procédés standards de la microélectronique.

## Revendications

1. Procédé de fabrication d'un dispositif microélectronique comprenant au moins un transistor (T1, T2) comprenant au moins deux canaux (41a, 41b, 41c) à base d'un matériau semiconducteur, une grille (50) entourant lesdits canaux (41a, 41b, 41c), une source (42) et un drain (43), lesdits canaux (41a, 41b, 41c) étant empilés selon une direction principale (z), ledit procédé comprenant les étapes suivantes :
• Fournir sur un substrat (S) un empilement (E) selon la direction principale (z) comprenant une pluralité de premières couches (10) en un premier matériau alternées avec une pluralité de deuxièmes couches (20) en un deuxième matériau, les premier et deuxième matériaux étant différents du matériau semiconducteur formant chaque canal (41a, 41b, 41c),
• Former dans cet empilement (E) des premières ouvertures (100) définissant des premiers motifs (101M),
• Former une grille sacrificielle (150) à cheval sur les premiers motifs (101M) et en partie dans les premières ouvertures (100),
• Former des premiers espaceurs (170) sur les premiers motifs (101M) et bordant la grille sacrificielle (150),
• Former dans les premiers motifs (101M) des deuxièmes ouvertures (200) définissant des deuxièmes motifs (102M),
• Retirer partiellement, à partir des deuxièmes ouvertures (200), le premier matériau des premières couches (10) sélectivement au deuxième matériau des deuxièmes couches (20), de sorte à former des premiers espaces (11) à l'aplomb des premiers espaceurs (170),
• Remplir les premiers espaces (11) par un matériau diélectrique pour former des espaceurs internes (171),
• Retirer totalement, à partir des deuxièmes ouvertures (200), le deuxième matériau des deuxièmes couches (11) sélectivement au premier matériau des premières couches (10), de sorte à former des deuxièmes espaces (21) et à exposer des parties de la grille sacrificielle (150),
• Former une couche diélectrique (30), dite couche diélectrique de grille, dans les deuxièmes espaces (21), sur les parties exposées de la grille sacrificielle (150) et des parties restantes des premières couches (10), à l'aplomb de la grille sacrificielle (150),
• Déposer une couche (40) à base d'un matériau semiconducteur dans les deuxièmes espaces (21), sur la couche diélectrique (30) de grille, à l'aplomb de la grille sacrificielle (150) et des premiers espaceurs (170), de sorte à former :
∘ des canaux (41a, 41b, 41c) à base du matériau semiconducteur à l'aplomb de la grille sacrificielle (150), et
∘ une source (42) et un drain (43) à base du matériau semiconducteur à l'aplomb des premiers espaceurs (170),
• Retirer la grille sacrificielle (150) de sorte à former des troisièmes ouvertures (300),
• Retirer totalement, à partir des troisièmes ouvertures (300), le premier matériau des parties restantes des premières couches (10), de sorte à former des troisièmes espaces (31) entourant les canaux (41) à base du matériau semiconducteur,
• Remplir par un matériau, dit matériau de grille, les troisièmes espaces (31), de façon à former une grille (50) dite enrobante entourant totalement les canaux (41a, 41b, 41c) de l'au moins un transistor (T1, T2).

2. Procédé selon la revendication précédente dans lequel le dépôt de la couche (40) à base du matériau semiconducteur se fait également sur les premiers espaceurs (170) et sur les espaceurs internes (171).

3. Procédé selon la revendication précédente dans lequel le dépôt de la couche (40) à base du matériau semiconducteur est configuré pour former des portions latérales de couche (40) à base du matériau semiconducteur sur des flancs du deuxième motif (102M) sensiblement parallèles à la direction principale (z), et des portions horizontales de couche (40) à base du matériau semiconducteur dans les deuxièmes espaces (21), tel que les portions latérales soient plus épaisses que les portions horizontales.

4. Procédé selon l'une quelconque des revendications précédentes dans lequel le dépôt de la couche (40) à base du matériau semiconducteur est effectué par dépôt chimique en phase vapeur ou par dépôt en couche atomique.

5. Procédé selon l'une quelconque des revendications précédentes dans lequel le matériau semiconducteur est un matériau bidimensionnel (2D) choisi parmi les dichalcogénures de métaux de transition MX2 avec M pris parmi le molybdène (Mo) ou le tungstène (W), et X pris parmi le soufre (S), le sélénium (Se) ou le tellure (Te).

6. Procédé selon l'une quelconque des revendications 1 à 4 dans lequel le matériau semiconducteur est choisi à base d'un oxyde semiconducteur, ou de graphène, de nitrure de bore hexagonal ou de phosphorène.

7. Procédé selon l'une quelconque des revendications précédentes dans lequel le premier matériau est choisi en SiGe et le deuxième matériau est choisi en Si ou inversement.

8. Procédé selon l'une quelconque des revendications précédentes dans lequel la formation de la grille sacrificielle (150) est effectuée de manière à ce que la grille sacrificielle (150) s'étende sur toute une hauteur des premières ouvertures (100).

9. Procédé selon l'une quelconque des revendications précédentes dans lequel le dépôt de la couche (40) à base du matériau semiconducteur est configuré pour que la couche (40) à base du matériau semiconducteur remplisse totalement les deuxièmes espaces (21).

10. Procédé selon l'une quelconque des revendications 1 à 8 dans lequel le dépôt de la couche (40) à base du matériau semiconducteur est configuré pour que la couche (40) à base du matériau semiconducteur remplisse partiellement les deuxièmes espaces (21), ledit procédé comprenant en outre, après dépôt de la couche (40) à base du matériau semiconducteur, un dépôt d'une couche diélectrique (71) configuré pour combler les deuxièmes espaces (21).

11. Procédé selon l'une quelconque des revendications précédentes dans lequel le substrat (S) est un substrat massif à base de silicium.

12. Procédé selon l'une quelconque des revendications précédentes dans lequel les premières ouvertures (100) sont formées selon une direction longitudinale (x) et les deuxièmes ouvertures (200) sont formées selon une direction transversale (y) perpendiculaire à la direction longitudinale (x), lesdites premières et deuxièmes ouvertures (100, 200) s'étendant jusqu'au substrat (S).

13. Procédé selon l'une quelconque des revendications précédentes dans lequel l'empilement (E) comprend autant de premières couches (10) du premier matériau que de deuxièmes couches (20) du deuxième matériau.

14. Procédé selon l'une quelconque des revendications précédentes dans lequel le dépôt de la couche (40) à base du matériau semiconducteur est configuré pour former des portions latérales de couche (40) à base du matériau semiconducteur sur des flancs du deuxième motif (102M) dans les deuxièmes ouvertures (200), le procédé comprenant en outre une formation de contacts de source et drain (60S, 60, 60D) dans lesdites deuxièmes ouvertures (200) et sur les portions latérales de couche (40) à base du matériau semiconducteur, avant le retrait de la grille sacrificielle (150).

## Patentansprüche

1. Verfahren zur Fertigung einer mikroelektronischen Vorrichtung, die mindestens einen Transistor (T1, T2), der mindestens zwei Kanäle (41a, 41b, 41c) auf Basis eines Halbleitermaterials umfasst, ein Gate (50), das die Kanäle (41a, 41b, 41c) umgibt, eine Source (42) und einen Drain (43) umfasst, wobei die Kanäle (41a, 41b, 41c) gemäß einer Hauptrichtung (z) gestapelt sind, wobei das Verfahren die folgenden Schritte umfasst:
• Bereitstellen auf einem Substrat (S) einer Stapelung (E) gemäß der Hauptrichtung (z), die eine Vielzahl von Schichten (10) aus einem ersten Material abwechselnd mit einer Vielzahl zweiter Schichten (20) aus einem zweiten Material umfasst, wobei sich das erste und das zweite Material von dem Halbleitermaterial, das jeden Kanal (41a, 41b, 41c) bildet, unterscheiden,
• Bilden in dieser Stapelung (E) erster Öffnungen (100), die erste Strukturen (101M) definieren,
• Bilden eines Opfer-Gates (150), das auf den ersten Strukturen (101M ) und zum Teil in den ersten Öffnungen (100) liegt,
• Bilden erster Abstandhalter (170) auf den ersten Strukturen (101M) und an das Opfer-Gate (150) angrenzend,
• Bilden in den ersten Strukturen (101M) zweiter Öffnungen (200), die zweite Strukturen (102M) definieren,
• teilweises Entfernen ausgehend von den zweiten Öffnungen (200) des ersten Materials der ersten Schichten (10) selektiv zu dem zweiten Material der zweiten Schichten (20) derart, dass erste Zwischenräume (11) senkrecht zu den ersten Abstandhaltern (170) gebildet werden,
• Füllen der ersten Zwischenräume (11) mit einem dielektrischen Material, um interne Abstandhalter (171) zu bilden,
• vollständiges Entfernen ausgehend von den zweiten Öffnungen (200) des zweiten Materials der zweiten Schichten (11) selektiv zu dem ersten Material der ersten Schichten (10) derart, dass zweite Zwischenräume (21) gebildet und Teile des Opfer-Gates (150) freigelegt werden,
• Bilden einer dielektrischen Schicht (30), dielektrische Gate-Schicht genannt, in den zweiten Zwischenräumen (21) auf den freigelegten Teilen des Opfer-Gates (150) und der restlichen Teile der ersten Schicht (10), senkrecht zu dem Opfer-Gate (150),
• Abscheiden einer Schicht (40) basierend auf einem Halbleitermaterial in den zweiten Zwischenräumen (21) auf der dielektrischen Gate-Schicht (30) senkrecht zu dem Opfer-Gate (150) und ersten Abstandhaltern (170), so dass Folgendes gebildet wird
∘ Kanäle (41a, 41b, 41c) auf Basis des Halbleitermaterials, senkrecht zu dem Opfer-Gate (150), und
∘ eine Source (42) und ein Drain (43) auf Basis des Halbleitermaterials, senkrecht zu den ersten Abstandhaltern (170),
• Entfernen des Opfer-Gates (150) derart, dass dritte Öffnungen (300) gebildet werden,
• vollständiges Entfernen ausgehend von den dritten Öffnungen (300) des ersten Materials der restlichen Teile der ersten Schichten (10) derart, dass dritte Zwischenräume (31) gebildet werden, die die Kanäle (41) auf Basis des Halbleitermaterials, umgeben,
• Füllen mit einem Material, Gate-Material genannt, der dritten Zwischenräume (31) derart, dass ein Gate (50), Hüll-Gate genannt, das die Kanäle (41a, 41b, 41c) des mindestens einen Transistors (T1, T2) vollständig umgibt, gebildet wird.

2. Verfahren nach dem vorstehenden Anspruch, wobei das Abscheiden der Schicht (40) auf Basis des Halbleitermaterials ebenfalls auf den ersten Abstandhaltern (170) und auf den internen Abstandhaltern (171) erfolgt.

3. Verfahren nach dem vorstehenden Anspruch, wobei das Abscheiden der Schicht (40) auf Basis des Halbleitermaterials dazu konfiguriert ist, seitliche Schichtabschnitte (40) auf Basis des Halbleitermaterials auf Flanken der zweiten Struktur (102M) zu bilden, die im Wesentlichen zu der Hauptrichtung (z) parallel sind, und horizontale Schichtabschnitte (40) auf Basis des Halbleitermaterials in den zweiten Zwischenräumen (21) derart, dass die seitlichen Abschnitte dicker sind als die horizontalen Abschnitte.

4. Verfahren nach einem der vorstehenden Ansprüche, wobei das Abscheiden der Schicht (40) auf Basis des Halbleitermaterials durch Gasphasenabscheidung oder durch atomare Schichtabscheidung erfolgt.

5. Verfahren nach einem der vorstehenden Ansprüche, wobei das Halbleitermaterial ein zweidimensionales Material (2D-Material) ist, das ausgewählt wird aus Übergangsmetall-Dichalkogeniden MX2 mit M genommen aus Molybdän (Mo) oder Wolfram (W) und X aus Schwefel (S), Selen (Se) oder Tellur (Te).

6. Verfahren nach einem der Ansprüche 1 bis 4, wobei das Halbleitermaterial ausgewählt wird auf Basis eines Halbleiteroxids oder von Grafiken, hexagonalem Bornitrid oder Phosphoren.

7. Verfahren nach einem der vorstehenden Ansprüche, wobei das erste Material aus SiGe ausgewählt wird, und das zweite Material aus Si oder umgekehrt ausgewählt wird.

8. Verfahren nach einem der vorstehenden Ansprüche, wobei das Bilden des Opfer-Gates (150) derart erfolgt, dass sich das Opfer-Gate (150) auf einer gesamten Höhe der ersten Öffnungen (100) erstreckt.

9. Verfahren nach einem der vorstehenden Ansprüche, wobei das Abscheiden der Schicht (40) auf Basis des Halbleitermaterials dazu konfiguriert ist, dass die Schicht (40) auf Basis des Halbleitermaterials die zweiten Zwischenräume (21) vollständig füllt.

10. Verfahren nach einem der Ansprüche 1 bis 8, wobei das Abscheiden der Schicht (40) auf Basis des Halbleitermaterials dazu konfiguriert ist, dass die Schicht (40) auf Basis des Halbleitermaterials die zweiten Zwischenräume (21) teilweise füllt, wobei das Verfahren außerdem nach dem Abscheiden der Schicht (40) auf Basis des Halbleitermaterials ein Abscheiden einer dielektrischen Schicht (71) umfasst, die dazu konfiguriert ist, die zweiten Zwischenräume (21) aufzufüllen.

11. Verfahren nach einem der vorstehenden Ansprüche, wobei das Substrat (S) ein massives Substrat auf Siliziumbasis ist.

12. Verfahren nach einem der vorstehenden Ansprüche, wobei die ersten Öffnungen (100) gemäß einer Längsrichtung (x) gebildet sind, und die zweiten Öffnungen (200) gemäß einer Querrichtung (y) senkrecht zu der Längsrichtung (x) gebildet sind, wobei sich die ersten und die zweiten Öffnungen (100, 200) bis zu dem Substrat (S) erstrecken.

13. Verfahren nach einem der vorstehenden Ansprüche, wobei die Stapelung (E) ebenso viele erste Schichten (10) aus dem ersten Material wie zweite Schichten (20) aus dem zweiten Material umfasst.

14. Verfahren nach einem der vorstehenden Ansprüche, wobei das Abscheiden der Schicht (40) auf Basis des Halbleitermaterials dazu konfiguriert ist, seitliche Schichtabschnitte (40) auf Basis des Halbleitermaterials auf Flanken der zweiten Struktur (102M) in den zweiten Öffnungen (200) zu bilden, wobei das Verfahren außerdem eine Bildung von Source- und Drain-Kontakten (60S, 60, 60D) in den zweiten Öffnungen (200) und auf den seitlichen Schichtabschnitten (40) auf Basis des Halbleitermaterials vor dem Entfernen des Opfer-Gates (150) umfasst.

## Claims

1. Method for manufacturing a microelectronic device comprising at least one transistor (T1, T2) comprising at least two channels (41a, 41b, 41c) with the basis of a semiconductor material, a gate (50) surrounding said channels (41a, 41b, 41c), a source (42) and a drain (43), said channels (41a, 41b, 41c) being stacked along a main direction (z), said method comprising the following steps:
• Providing, on a substrate (S), a stack (E) along the main direction (z) comprising a plurality of first layers (10) made of a first material alternated with a plurality of second layers (20) made of a second material, the first and second materials being different from the semiconductor material forming each channel (41a, 41b, 41c),
• Forming, in this stack (E), first openings (100) defining first patterns (101M),
• Forming a sacrificial gate (150) mounted on the first patterns (101M) and partially in the first openings (100),
• Forming first spacers (170) on the first patterns (101M) and bordering the sacrificial gate (150),
• Forming, in the first patterns (101M), second openings (200) defining second patterns (102M),
• Removing partially, from the second openings (200), the first material of the first layers (10) selectively at the second material of the second layers (20), so as to form first spaces (11) in vertical alignment with the first spacers (170),
• Filling the first spaces (11) with a dielectric material to form internal spacers (171),
• Removing totally, from the second openings (200), the second material from the second layers (11) selectively at the first material from the first layer (10), so as to form second spaces (21) and to expose parts of the sacrificial gate (150),
• Forming a dielectric layer (30), called gate dielectric layer, in the second spaces (21), on the exposed parts of the sacrificial gate (150) and remaining parts of the first layers (10), in vertical alignment with the sacrificial gate (150),
• Depositing a layer (40) with the basis of a semiconductor material in the second spaces (21), on the gate dielectric layer (30), in vertical alignment with the sacrificial gate (150) and with the first spacers (170), so as to form:
∘ channels (41a, 41b, 41c) with the basis of the semiconductor material in vertical alignment with the sacrificial gate (150), and
∘ a source (42) and a drain (43) with the basis of the semiconductor material in vertical alignment with the first spacers (170),
• Removing the sacrificial gate (150) so as to form third openings (300),
• Removing totally, from the third openings (300), the first material of the remaining parts of the first layers (10), so as to form third spaces (31) surrounding the semiconductor material-based channels (41),
• Filling with a material, called gate material, the third spaces (31), so as to form a so-called gate-all-around (50), totally surrounding the channels (41a, 41b, 41c) of the at least one transistor (T1, T2).

2. Method according to the preceding claim, wherein the deposition of the semiconductor material-based layer (40) is also done on the first spacers (170) and on the internal spacers (171).

3. Method according to the preceding claim, wherein the deposition of the semiconductor material-based layer (40) is configured to form semiconductor material-based lateral layer portions (40) on flanks of the second pattern (102M) substantially parallel to the main direction (z), and semiconductor material-based horizontal layer portions (40) in the second spaces (21), such that the lateral portions are thicker than the horizontal portions.

4. Method according to any one of the preceding claims, wherein the deposition of the semiconductor material-based layer (40) is done by chemical vapour deposition or by atomic layer deposition.

5. Method according to any one of the preceding claims, wherein the semiconductor material is a two-dimensional (2D) material chosen from among MX2 transition metal dichalcogenides, with M taken from among molybdenum (Mo) or tungsten (W), and X taken from among sulphur (S), selenium (Se) or tellurium (Te).

6. Method according to any one of claims 1 to 4, wherein the semiconductor material is chosen with the basis of a semiconductor oxide, or graphene, hexagonal boron nitride or phosphorene.

7. Method according to any one of the preceding claims, wherein the first material is chosen as SiGe and the second material is chosen as Si, or vice versa.

8. Method according to any one of the preceding claims, wherein the formation of the sacrificial gate (150) is done such that the sacrificial gate (150) extends over an entire height of the first openings (100).

9. Method according to any one of the preceding claims, wherein the deposition of the semiconductor material-based layer (40) is configured such that the semiconductor material-based layer (40) totally fills the second spaces (21).

10. Method according to any one of claims 1 to 8, wherein the deposition of the semiconductor material-based layer (40) is configured such that the semiconductor material-based layer (40) partially fills the second spaces (21), said method further comprising, after deposition of the semiconductor material-based layer (40), a deposition of a dielectric layer (71) configured to fill the second spaces (21).

11. Method according to any one of the preceding claims, wherein the substrate (S) is a silicon-based solid substrate.

12. Method according to any one of the preceding claims, wherein the first openings (100) are formed along a longitudinal direction (x) and the second openings (200) are formed along a transverse direction (y) perpendicular to the longitudinal direction (x), said first and second openings (100, 200) extending up to the substrate (S).

13. Method according to any one of the preceding claims, wherein the stack (E) comprises as many first layers (10) of the first material as second layers (20) of the second material.

14. Method according to any one of the preceding claims, wherein the deposition of the semiconductor material-based layer (40) is configured to form semiconductor material-based lateral layer portions (40) on flanks of the second pattern (102M) in the second openings (200), the method further comprising a formation of source and drain contacts (60S, 60, 60D) in said second openings (200) and on the semiconductor material-based lateral layer portions (40), before the removal of the sacrificial gate (150).
